Europäisches Patentamt

European Patent Office

Office européen des brevets

(11) Veröffentlichungsnummer : **0 120 347**
**B1**

## (12) EUROPÄISCHE PATENTSCHRIFT

(45) Veröffentlichungstag der Patentschrift :
20.09.89

(21) Anmeldenummer : 84102294.0

(22) Anmeldetag : 03.03.84

(51) Int. Cl.⁴ : **H 01 H 47/18, H 03 K 17/28**

54 Zeitschalter.

(30) Priorität : 19.03.83 DE 8308537 U

(43) Veröffentlichungstag der Anmeldung :
03.10.84 Patentblatt 84/40

(45) Bekanntmachung des Hinweises auf die Patenterteilung : 20.09.89 Patentblatt 89/38

(84) Benannte Vertragsstaaten :
AT BE CH DE FR GB IT LI LU NL SE

(56) Entgegenhaltungen :
CH—A— 413 050
DE—C— 960 298
FR—A— 2 232 115
GB—A— 427 430
US—A— 3 250 924

(73) Patentinhaber : Joh. Vaillant GmbH u. Co.
Berghauser Strasse 40 Postfach 10 10 20
D-5630 Remscheid 1 (DE)
DE IT LU SE
COFRABEL N.V.
15, rue Golden Hope straat
B-1620 Drogenbos (BE)
BE
VAILLANT S.A.R.L
4, Rue des Oliviers Orly-Sénia 326
F-94537 Rungis Cedex (FR)
FR
VAILLANT Ges.m.b.H
Forchheimergasse 7 Postfach 56
A-1233 Wien (AT)
AT
Vaillant Ltd.
Vaillant House Medway City Estate Trident Close
Rochester Kent ME2 4EZ (GB)
GB
SCHONEWELLE B.V.
Ellermanstraat 17
NL-1099 BX Amsterdam (NL)
NL
Vaillant GmbH
Riedstrasse 8
CH-8953 Dietikon 1 (CH)
CH LI

(72) Erfinder : Hangauer, Wilfried Dr.
Heidenstr. 15
D-5609 Hückeswagen (DE)

(74) Vertreter : Heim, Johann-Ludwig
c/o Joh. Vaillant GmbH u. Co Postfach 10 10 20
Berghauser Strasse 40
D-5630 Remscheid 1 (DE)

## Beschreibung

Die vorliegende Erfindung bezieht sich auf einen Zeitschalter gemäß dem Oberbegriff des Hauptanspruchs.

Ein solcher Zeitschalter ist bereits bekanntgeworden aus der US-PS-3250924. Bei diesem Stand der Technik liegen im Ladefall des Kondensators aus der Sicht des Schalters der Kondensator und der Oszillator in Verbindung mit dem Transistor und der Spule parallel. Aufgrund dieser Schaltung ist es möglich, daß trotz geschlossenen Schalters der Oszillator schwingen kann. wenn nämlich im Verbindungszweig zwischen dem Kontakt und dem Widerstand genügend Hochohmigkeit herrscht. Ein Schwingen wäre auch dann möglich, wenn die Leitung zwischen dem Kollektor des Transistors und dem Schalter lang genug ist bzw. eine Rohrimpedanz aufweist. Bei den Schwingungen handelt es sich dann allerdings um parasitäre Schwingungen, die aber dennoch zu einem Ausgangssignal führen würden, was bei der Verwendung des Zeitschalters nach der Erfindung bei einem Feuerungsautomaten unbedingt vermieden werden muß.

Aus der FR-PS 2 232 150 ist es bekannt, parallel zu den Betriebsspannungsanschlüssen des Oszillators eine Rückstromdiode zu schalten. Aus dieser Entgegenhaltung ist es auch bekannt, zwecks Verwendung kleinerer Übertrager eine Oszillatorfrequenz von 1 kHz vorzusehen.

Zeitschalter werden bei Feuerungsautomaten von brennstoffbeheizten Wärmequellen benötigt, um die Brennstoffzufuhr dann abzuschalten, wenn innerhalb einer bestimmten Zeit, der Sicherheitszeit, eine Zündung des Brenners der brennstoffbeheizten Wärmequelle nicht erfolgte.

Hierzu ist es bekannt, von einer Betriebsgleichspannung einen Kondensator aufzuladen und mit der Freigabe des Brennstoffventils den Kondensator von der speisenden Betriebsspannung abzuschalten und auf eine Impedanz umzuschalten, wobei diese Impedanz von einem Verzögerungsrelais dargestellt wird. Der Kondensatorentladestrom hält das Verzögerungsrelais für eine gewisse Zeit angezogen.

Erfolgt innerhalb dieser Zeit die Zündung, so wird der Zeitschalter für die weitere Dauer des Betriebsprogramms der brennstoffbeheizten Wärmequelle nicht mehr benötigt, erfolgt die Zündung nicht, schaltet der Zeitschalter die Wärmequelle ab.

Diese bekannten Zeitschalter waren demgemäß elektromechanisch aufgebaut und weisen im Zeitverhalten eine unzumutbar große Streuung auf. Um diese Streuung in erträglichen Grenzen halten zu können, waren sehr kleine Toleranzgrenzen für die verwendeten Bauteile nötig, die zu erheblichen Kosten führen.

Der vorliegenden Erfindung liegt die Aufgabe zugrunde, eine vollelektronisch aufgebaute Zeitschaltung zu schaffen, die eigensicher ist und an die Toleranz der Bauelemente nur geringe Ansprüche stellt.

Die Lösung dieser Aufgabe liegt in den Merkmalen des Hauptanspruchs.

Weitere Ausgestaltungen und besonders vorteilhafte Weiterbildungen der Erfindung sind Gegenstand der Unteransprüche beziehungsweise der nachfolgenden Beschreibung, die anhand der Ausführungsbeispiele der Figuren eins bis drei die Erfindung erläutern.

Es zeigen Figur eins ein Prinzipschaltbild des Zeitschalters Figur zwei eine mögliche Darstellung der Stromquelle und Figur drei eine weitere Schaltungsmöglichkeit für die Stromquelle.

In allen drei Figuren bedeuten gleiche Bezugszeichen jeweils die gleichen Einzelheiten.

An eine speisende Gleichspannungsquelle 1 mit dem Pluspol 2 und dem Minuspol 3 ist der Zeitschalter 4 angeschlossen. Der Zeitschalter 4 weist als wesentliche Bauelemente einen Oszillator 5, einen Kondensator 6, eine Stromquelle 7, eine Diode 8 und einen Widerstand 9 auf sowie weiterhin einen Verstärker 10, ein Relais 11 und eine Last 12.

Vom Pol 2 führt eine Leitung 13 zu einem Schaltarm 14 eines Umschalters 15, dessen einer Kontakt 16 mit einer Leitung 17 verbunden ist, die zum Kontaktarm 18 eines Arbeitskontaktes 19 führt, der Zum Relais 11 gehört. Der andere Kontakt 20 des Umschalters 15 ist mit einer Leitung 21 verbunden, die zum Kondensator 6 führt. Von der Leitung 21 zweigt eine Leitung 22 ab, die zur Stromquelle 7 führt, die im Ausführungsbeispiel der Figur eins als Konstantstromquelle ausgebildet ist, durch die ein Strom I in der eingezeichneten Pfeilrichtung fließt. Der andere Anschluß des Kondensators ist von einer Leitung 23 gebildet, in die der Widerstand 9 eingeschleift ist und die zu einem Verzweigungspunkt 24 führt. An dem Verzweigungspunkt 24 ist die Diode 8, in Durchflußrichtung gepolt, angeschlossen, deren anderer Anschluß zu einem Verzweigungspunkt 25 führt, der über eine Leitung 26 mit dem negativen Pol der Gleichspannungsquelle 1 verbunden ist.

An dem Punkt 24 ist über eine Leitung 27 der Oszillator 5 angeschlossen, und zwar so, daß der negative Anschluß des Oszillators an den Pluspol der Diode geführt ist. Der Oszillator ist auf der anderen Seite mit einer Leitung 28 verbunden, die ihrerseits mit der Leitung 26 verbunden ist, und zwar in einem Verzweigungspunkt 29.

Der Oszillator liegt demgemäß parallel zur Diode 8 und ist so gepolt, daß er nur zu schwingen imstande ist, wenn die Diode 8 gesperrt ist. Eine Ausgangsleitung 30 des Oszillators führt zu einem Eingang 31 des Verstärkers 10, der außerdem über einen Widerstand 32 mit der Leitung 17 verbunden ist. Über Leitungen 33 und 34 ist der Verstärker an die speisende Gleichspannung 1 angeschlossen. Der Ausgang 35 des Verstärkers 10 ist über eine Leitung 36, in der die Primärspule eines Ferritkern-Transformators 37 angeordnet ist, mit der Leitung 26 verbunden.

Der Ferritkern 38 besitzt eine Sekundärspule 39, die mit ihren beiden Polen an eine Graetz-Gleichrichterbrücke 40 angeschlossen ist. Die beiden anderen Pole der Graetz-Gleichrichterbrücke sind an die Spule 41 des Relais 11 angeschlossen.

Der Kontakt 42 des Arbeitskontaktes 19 ist über eine Leitung 43 mit dem Lastwiderstand 12 verbunden, im Ausführungsbeispiel handelt es sich bei diesem Widerstand um ein Brennstoffmagnetventil eines Umlauf-Gaswasserheizers. Die Rückführung von der Last ist über eine Leitung 44 bewirkt, die unmittelbar mit der Leitung 26 verbunden ist.

In der Figur eins ist der Ruhezustand, das heißt der spannungslose Zustand aller Bauteile, gezeigt.

Wird nun über einen nicht dargestellten Schalter die speisende Gleichspannung 1 angeschlossen, so wird im Hinblick auf die gezeichnete Stellung des Umschalters 15 der Kondensator 6 über die Leitungen 13 und 21 geladen, wobei der Widerstand 9 die Aufgabe hat, den Ladestrom zu begrenzen. Die Diode 8 ist als Kurzschluß zu verstehen, da sie in Durchflußrichtung gepolt ist. Der weitere Stromfluß geschieht über die Leitung 26 und die Klemme 3.

Da die Konstantstromquelle 7 an der speisenden Gleichspannung liegt, fließt durch sie bzw. durch die Leitung 22 der Strom I. Wenn der Kondensator aufgeladen ist, ist der Verzweigungspunkt 24 auf dem gleichen Potential wie der Verzweigungspunkt 25, das heißt, am Oszillator liegt keine Potentialdifferenz an. Der Oszillator kann unter diesen Betriebsbedingungen nicht schwingen, das heißt, auf der Leitung 30 herrscht kein Spannungssignal. Damit kann der Verstärker kein Spannungssignal verstärken, so daß das Relais 11 abgefallen bleibt. Damit bleibt der Kontakt 19 geöffnet und die Last stromlos. Wird nun von der brennstoffbeheizten Wärmequelle Wärme angefordert, so wird der Kontakt 14 umgeschaltet, so daß der Kontaktarm 14 den Kontakt 20 verläßt und auf den Kontakt 16 umschaltet. Dies wirkt sich bezüglich der Last zur Zeit noch nicht aus. Der Kondensator beginnt jetzt mit seiner Entladung, da er von der speisenden Gleichspannung getrennt ist. Die Entladung erfolgt über die Konstantstromquelle 7, das Leitungsstück der Leitung 26 zwischen den Verzweigungspunkten 25 und 29, den Oszillator 5, den Verzweigungspunkt 24, den Widerstand 9 und Leitungsstück 23. Nunmehr stellt der Entladestrom des Kondensators den Betriebsstrom für den Oszillator dar, der nunmehr beginnt zu schwingen. Der Betriebsstrom, der durch den Oszillator fließt, entspricht hierbei dem Strom I. Damit erscheint auf der Ausgangsleitung 30 eine hochfrequente Spannung, da die Oszillatorfrequenz etwa 10 Kilohertz beträgt. Die Frequenz dieser Spannung liegt um ein Vielfaches über der Netzfrequenz von 50 Hertz. Die Spannung wird im Verstärker 10 verstärkt, der mit dem Umschalten des Umschaltkontakts 15 bereits an die speisende Gleichspannung gelegt ist. Somit steht die verstärkte hochfrequente Spannung am Ausgang 35 des Verstärkers an und wird von dem Ferritkern 38 übertragen, von der Graetz-Brücke gleichgerichtet und speist die Spule 41 des Relais 11. Das Relais zieht an und schließt seinen Arbeitskontakt 19. Nunmehr ist die speisende Gleichspannung 1 auf die Spule des Magnetventils 12 durchgeschaltet, der Brennstoffweg ist freigegeben.

Jetzt beginnt die Sicherheitszeit zu laufen, die damit beendet wird, daß der Kontakt 19 wieder öffnet. Dies kommt wie folgt zustande : infolge der Speisung des Leistung aufnehmenden Oszillators durch den Kondensator 6 sinkt dessen Ladespannung linear im Hinblick auf die Konstantstromquelle 7. Das bedeutet, daß bei Unterschreiten eines bestimmten Spannungswertes der Speisestrom für den Oszillator abrupt abreißt. Dieses Abreißen des Speisestroms bewirkt ein Einstellen des Schwingungsbetriebs im Oszillator und damit ein Stromloswerden der Spule 41 des Relais 11 und das Öffnen des Kontakts 19. Hat aber während dieser Zeitspanne die Überwachungseinrichtung für die Flamme des Brenners der brennstoffbeheizten Wärmequelle das Zünden gemeldet, so wird an die Spule 41 des Relais 11 eine nicht dargestellte Spannungsquelle gelegt, die für das weitere Schließen des Kontakts 19 sorgt.

Aus der Figur zwei ist die Ausbildung der Konstantstromquelle 7 in ihren Einzelheiten sowie die Ausgestaltung des Oszillators 5 und des Verstärkers 10 im einzelnen ersichtlich.

Es ist ersichtlich, daß die Konstantstromquelle aus einem Transistor 50 besteht, dessen Basis über die Leitung 51 an eine Serienschaltung zweier Widerstände 52 und 53 angeschlossen ist, und zwar zwischen beide Widerstände, wobei die Endpunkte der beiden Widerstände mit den Leitungen 13 und 26 verbunden sind.

Die Leitung 22 geht von dem nunmehr als Arbeitskontakt ausgebildeten Kontakt 15 ab und führt über die Kollektoremitterstrecke des Transistors 50 und einen Widerstand 54 zur Leitung 26. Die Schaltung des Kondensators 6, der Diode 8 und des Widerstandes 9 hat sich nicht verändert. Der Oszillator 5 besteht im wesentlichen aus 3 Transistoren 55, 56 und 57, von denen im schwingenden Zustand einer der beiden Transistoren 56 und 57 gesperrt, der andere leitend ist. Weiterhin ist ein Widerstandskondensatornetzwerk vorhanden, um die Schwingungsfähigkeit sicherzustellen. Der Ausgang 30 des Oszillators ist an den aus 2 Leistungstransistoren bestehenden Verstärker 10 angeschlossen, an deren Ausgangspunkt 35 die Figur eins die Primärspule 37 des Ferritkerns 38 angeschlossen ist.

Der Widerstand 32 ist einerseits an die Leitung 17 angeschlossen, zum anderen an die Basen der beiden Leistungstransistoren 10 und auch an den Ausgang 30 des Oszillators 5.

Wenn bei schwingendem Oszillator 5 der Transistor 57 gerade leitend ist, dann fließt der Entladestrom des Kondensators 6 über die Leitung 22, die Kollektoremitterstrecke des Transistors 50, den Widerstand 54, über die an die Klemmen 2 und 3 angeschlossene Gleichspannungsquelle, die Leitung 17, den Widerstand 32, die Kollektoremitterstrecke des Transistors 57, den Widerstand 9 und die Leitung 23 zurück zum Kondensator 6. Sperrt dagegen der Transistor 57 gerade und ist stattdessen der Transistor 56 leitend, so fließt der Entladestrom des Kondensators 6 über die Leitung 22, die Emitterkollektorstrecke des Transistors 50, den Widerstand 54, die Leitung 26, die Kollektoremitterstrecke des Transistors 56, die Leitung 27, den Widerstand 9 und die Leitung 23 zurück zum Kondensator. Wesentlich ist nun, daß in der zuerst genannten Phase der durch den Strom I durch den Widerstand 32 gegebene Spannungsabfall dort den Oszillator zum Schwingen bringt, da dieser Spannungsabfall notwendig ist, um über den Transistor 55 den Transistor 56 zum Leiten zu bringen, der dann seinerseits den Transistor 57 sperrt.

Das bedeutet, daß die Größe des Widerstandes 32 in Abhängigkeit von der Größe des Stroms I zu bemessen ist. Bei den Ausführungsbeispielen gemäß Figur eins und zwei wurde von einer mit analogen Bauelementen aufgebauten Konstantstromquelle 7 ausgegangen, die man, wie die Ausführungsbeispiele der Figuren drei und vier zeigen, auch als gesteuerte Stromquelle digital aufbauen kann.

Zentraler Bestandteil der gesamten gesteuerten Stromquelle 60 ist ein Schieberegister 61, das eine Vielzahl von Stufen, im vorliegenden Fall 4 Stufen, aufweist. Dieses Schieberegister wird aus einem Netzwechselspannungsanschluß 62 über einen Frequenzteiler 63, der mit einem Teilungsverhältnis von 50 : 1 arbeitet, und über eine Leitung 64 mit Impulsen gespeist, die, ausgehend von einer Startstellung, bei der der erste Platz des Schieberegisters eine logische 1 aufweist und alle anderen eine logische 0 aufweisen, fortlaufend weitergeschaltet wird, bis alle Stufen den logischen Zustand 1 erreicht haben. Weiterhin ist eine Schaltung 65 vorgesehen, die diesen Startzustand des Schieberegisters über eine Leitung 66 vorgibt.

Vom Pluspol 2 der speisenden Gleichspannung führt die Leitung 13 wiederum zu dem als Arbeitskontakt 15 ausgebildeten Kontakt, an dem sich unter Zwischenschaltung einer Diode 67 die Leitung 21 mit dem Kondensator 6 anschließt. Zwischen Kontakt 15 und Diode 67 ist eine Leitung 68 angeschlossen, die zum Schieberegister führt und dessen Steuerung dient. Die Leitung 68 ist über einen Widerstand 69 mit dem negativen Pol 3 der speisenden Gleichspannung verbunden.

Es ist ein Netzwerk 70 aus vier an einem Ende miteinander durch eine Leitung 71 verbundenen Widerständen 72, 73, 74 und 75 vorgesehen, wobei die Zahl der Widerstände gleich der Stufenanzahl des Schieberegisters gehalten ist. Die Leitung 71 ist an die Leitung 21 zwischen Diode 67 und Kondensator 6 angeschlossen. Die einzelnen Widerstände 72 bis 75 sind über je einen Schalter 76, 77, 78 und 79 mit der Leitung 26 verbunden. Diese Schalter werden alle vom Schieberegister über Wirkverbindungen 80, 81, 82 und 83 gesteuert. Die Schalter 76 bis 79 können mechanische Schalter, können aber auch Halbleiterbauelemente sein. Sie können weiterhin auch Bestandteile des Schieberegisters selbst sein. Die Wirkverbindung 80 ist über eine weitere Wirkverbindung 84 mit dem Eingang des Schieberegisters 61 verbunden.

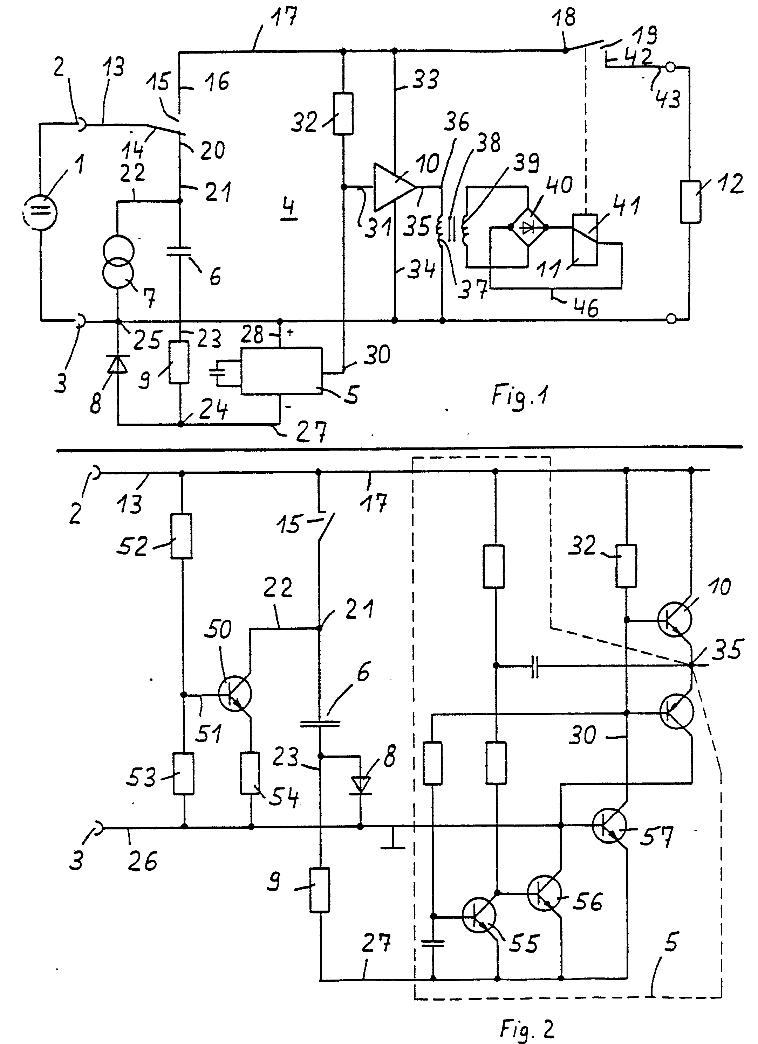

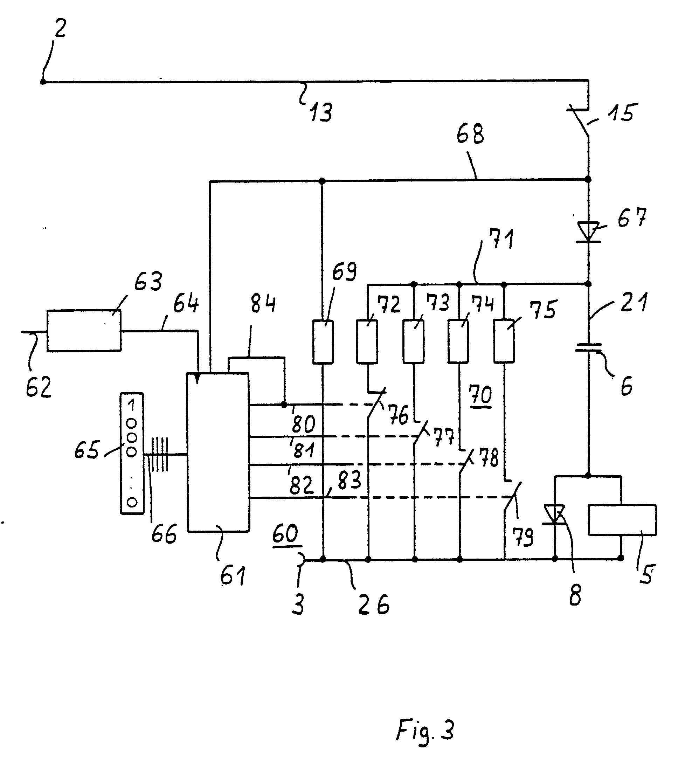

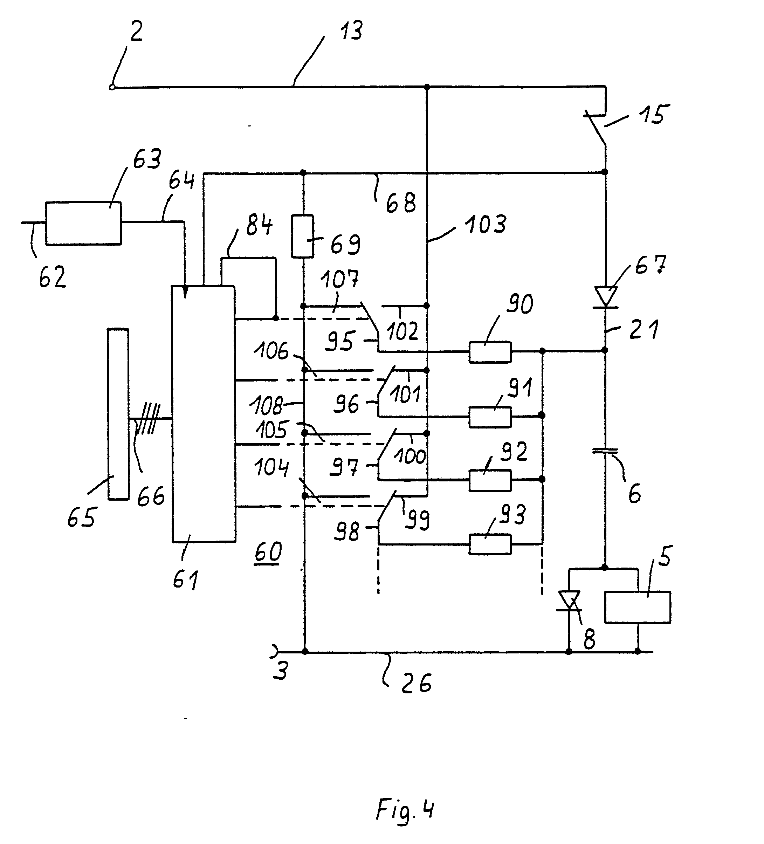

Die eben beschriebene Schaltung gemäß Figur 3 arbeitet wie folgt : ausgehend vom dargestellten Ruhezustand ist der Kontakt 15 sowie der Schalter 76 geschlossen, die Schalter 77 bis 79 hingegen geöffnet. Durch das in der Schaltung 65 eingespeicherte Programm ist das Schieberegister in seinem Startzustand, der dadurch definiert ist, daß über die Wirklinie 80 der Kontakt 76 geschlossen ist, das Schieberegister somit auf dem ersten Schritt steht. Die übrigen Wirklinien 81 bis 83 sind stromlos, die zugehörigen Kontakte demgemäß geöffnet.

Die am Anschluß 62 anstehende Netzfrequenz wird im Frequenzuntersetzer 63 geteilt, die Impulse stehen auf der Leitung 64 am Eingang des Schieberegisters an, sind aber noch wirkungslos, da über die Leitung 68 noch Steuerspannung am Schieberegister ansteht.

Wird diese Steuerspannung unterbrochen, indem der Kontakt 15 geöffnet wird, so beginnt sich der Kondensator, wie bereits beim Ausführungsbeispiel gemäß den Figuren eins und zwei beschrieben, zu entladen und zwar über die Leitung 71, den Widerstand 72, den Kontakt 76, die Leitung 26 und den Oszillator 5. Das bedeutet, daß der fließende Strom gemäß einer exponentiell verlaufenden Entladekurve kleiner wird. Die Taktzeit des Schieberegisters ist nun so gewählt, daß die Zeit zwischen den einzelnen Stufen des Schieberegisters, im vorliegenden Fall vier Stufen, kleiner gewählt ist als die Zeit, bei der der fließende Strom I den kritischen Wert erreicht, bei dem der Oszillator das Schwingen einstellt. Demgemäß schaltet das Schieberegister auf den nächsten Schritt um, bevor dieser Strom I den kritischen Wert erreicht hat. Damit ist für den Entladestrom I nunmehr ein Parallelweg aus den beiden Widerständen 72 und 73 geschaffen, das heißt, der Strom steigt im zweiten Schritt wieder an und beginnt wieder, exponentiell zu fallen. Auch hier schaltet das Schieberegister auf den nächsten Schritt um, bevor dieser Strom den kritischen Wert erreicht hat. Nunmehr kann der Strom wieder ansteigen, da eine Parallelschaltung aus drei Widerständen vorliegt usw. Nach Zuschalten des letzten Widerstandes 75 wird irgendwann der Strom I den kritischen Wert unterschreiten, so daß der Oszillator aufhört zu schwingen. Der Vorteil dieser Schaltung liegt darin, daß die gesamte Sicherheitszeit in Endstufen unterteilt wird, wobei nur der Ablauf der letzten Stufe zeitmäßig nicht ohne weiteres gesteuert werden kann, da hier der zeitliche Verlauf von den Widerstands- und Spannungstoleranzen bestimmt wird. Die übrigen Einzelzeiten während der Umschaltschritte sind hingegen zeitlich exakt definierbar.

Nach dem Ausführungsbeispiel gemäß Figur vier ist es auch möglich, die gesteuerte Stromquelle 60 durch eine abweichende Schaltung darzustellen. Der wesentliche Unterschied zwischen den Schaltungen von Figur drei und Figur vier besteht darin, daß in der Figur vier die vier Widerstände 90, 91, 92 und 93 gleich und die Widerstände 72 bis 75 in Figur drei verschieden groß sind.

Die Widerstände 90 bis 93 sind an ihrem einen Ende parallel durch eine Leitung 94 miteinander verbunden, und diese Leitung ist an die Leitung 21 zwischen dem Minuspol der Diode 67 und dem Kondensator 6 angeschlossen. Diese Widerstände führen jeweils zu einem Kontaktarm 95, 96, 97 und 98 eines Umschalters, dessen jeweils einer Kontakt 99, 100, 101 beziehungsweise 102 alle an eine Leitung 103 gemeinsam angeschlossen sind, die mit der Leitung 13 verbunden ist. Die jeweils anderen Kontakte der Umschalter 104, 105, 106 und 107 sind gleichermaßen alle zusammengefaßt und gemeinsam mit einer Leitung 108 verbunden, die den Widerstand 69 mit der Leitung 26 verbindet. Das Wesentliche der Schaltung besteht darin, daß der Mittelpunkt der Umschaltarme 98 bis 102 entweder an die Leitung 103, das heißt an positive Betriebsspannung, angeschlossen ist oder an der Leitung 108, das heißt an negativer Betriebsspannung, liegt. Somit ist die Leitung 94 je nach Stellung der Kontakte mit dem einen oder mehreren der zugehörigen Widerstände 90 bis 93 entweder an positive oder an negative Betriebsspannung angeschlossen.

Die übrigen Bauelemente entsprechen in ihrem Aufbau denen der Figur drei.

Die Funktion dieser Schaltung ist wie folgt : wird vom Ruhezustand bei geschlossenem Kontakt 15 ausgegangen, ist der Kontaktarm 95 mit negativem Potential, das heißt mit dem Kontakt 107, alle übrigen Umschalter 96 bis 98 jedoch über die zugehörigen Kontakte mit positiver Betriebsspannung über die Leitung 103 verbunden. Dieser Zustand entspricht dem Startzustand des Schieberegisters, dieser Zustand ist auch in die Schaltung 65 eingespeichert. Wird nunmehr der Kontakt 15 geöffnet, beginnt die Sicherheitszeit zu laufen. Der Kondensator 6 entlädt sich über den Widerstand 90, den Umschalter 95, die Leitung 108, die Leitung 26 und den Oszillator 5. Diese Entladung findet aber von der Spitzenspannung nur bis zu einer Spannungshöhe statt, die gegeben ist durch eine Gegenspannung, die aus der speisenden Gleichspannung und dem Spannungsteiler resultiert, der aus der Parallelschaltung der drei verbleibenden Widerstände 91 bis 93 und dem Widerstand 90 resultiert. Der Strompfad dieser Kompensationsspannung geht über die Leitungen 13 und 103, über die drei parallel liegenden Widerstände 91 bis 93, die Leitung 94, den Widerstand 90 und die Leitung 108. Die Höhe dieser Spannungsteilerspannung definiert die niedrigstmögliche Spannung, auf die sich der Kondensator 6 im ersten Schritt entladen kann.

Die Taktzeit des Schieberegisters ist wiederum so bemessen, daß das Schieberegister auf den zweiten Schritt umschaltet, das heißt, Umschalten des Umschalters 96, bevor der kritische Entladestrom erreicht wird. Nunmehr entlädt sich der Kondensator von der niedrigeren Spannung am Ausgang der ersten Schaltzeit auf eine niedrigere Spannungsstufe, die gegeben ist durch den Spannungsteiler, wenn die beiden Widerstände 90 und 91 einerseits parallel liegen und andererseits mit der Parallelschaltung aus den Widerständen 92 und 93 verbunden sind. Der Strom steigt schlagartig auf einen gleich hohen Wert entsprechend dem Anfangswert und fällt nach einer E-Funktion, die der E-Funktion im ersten Schritt gleich ist.

Es folgen dann noch die beiden angenommenen weiteren Schritte, wobei nach Ablauf des vierten Schrittes die Restspannung so klein ist, daß der resultierende Restentladungsstrom I so klein wird, daß der Oszillator nicht mehr zu schwingen imstande ist. Somit ist auch hier die Sicherheitszeit durch vier einzelne Zeitstufen definiert.

## Patentansprüche

1. Zeitschalter mit einer speisenden Gleichspannungsquelle (1) und einem von ihr über einen Schalter (15) ladbaren Kondensator (6), der über ein eine Last (12) schaltendes, einen Oszillator (5) aufweisendes Glied entladen werden kann, wobei das Glied vom Kondensator (6) während dessen Entladephase vom Entladestrom durchflossen wird, dadurch gekennzeichnet, daß der Kondensator (6) mit einer Parallelschaltung aus einem Gleichrichter (8) und dem Oszillator (5) in Serie liegt und daß der Oszillator nur in einer Richtung von einem Mindeststrom zum Schwingen gebracht werden kann.

2. Zeitschalter nach Anspruch 1, dadurch gekennzeichnet, daß der Kondensator (6) mit einer Diode (8) und einem Widerstand (9) in Serie liegt und daß die Betriebsspannungsanschlüsse (28, 27) des Oszillators (5) parallel zur Diode (8) liegen.

3. Zeitschalter nach Anspruch 1 oder 2, dadurch gekennzeichnet, daß die Diode (8) gegensinnig zu der Betriebspannung des Oszillators (5), die zum Schwingen des Oszillators (5) führt, gepolt ist.

4. Zeitschalter nach einem der Ansprüche 1 bis 3, dadurch gekennzeichnet, daß der Ausgang (30) des Oszillators über einen Widerstand (32) mit einem Pol (2) der speisenden Betriebsspannung (1) verbunden ist.

5. Zeitschalter nach einem der Ansprüche 1 bis 4, dadurch gekennzeichnet, daß die Frequenz der Oszillatorspannung an dessen Ausgang (30) sehr viel größer als 50 Hertz, insbesondere 10 Kilohertz, ist.

6. Zeitschalter nach einem der Ansprüche 1 bis 5, dadurch gekennzeichnet, daß in Serie mit dem Kondensator (6) in dessen Entladestromkreis ein weiterer Widerstand liegt.

7. Zeitschalter nach Anspruch 6, dadurch gekennzeichnet, daß dieser weitere Widerstand durch eine Konstantstromquelle (7) ersetzt ist.

8. Zeitschalter nach Anspruch 6, dadurch gekennzeichnet, daß der weitere Widerstand von einer gesteuerten Stromquelle (Figur drei, Figur vier) ersetzt ist.

9. Zeitschalter nach einem der Ansprüche 1 bis 7, dadurch gekennzeichnet, daß im Ausgang (30) des Oszillators (5) ein Widerstand (32) angeordnet ist, der so bemessen ist, daß der Spannungsabfall an ihm beim Fluß des Entladestroms des Kondensators (6) den Oszillator zum Schwingen bringt.

10. Zeitschalter nach Anspruch 7, dadurch gekennzeichnet, daß die gesteuerte Stromquelle (60) aus einer Parallelschaltung von Widerständen (72, 73, 74, 75...) besteht, von denen jeder dieser Widerstände mit einem Schalter (76, 77, 78, 79...) in Serie liegt, wobei die Widerstände einer nach dem anderen in den Entladekreis des Kondensators (6) parallel zueinander durch eine Vorrichtung (61) eingeschaltet werden.

11. Zeitschalter nach Anspruch 7, dadurch gekennzeichnet, daß die gesteuerte Stromquelle (Figur vier) aus einem an der speisenden Gleichspannung (2, 3) liegenden Spannungsteiler (90, 91, 92 93) besteht dessen Teilungsverhältnis von einer Vorrichtung (61) umschaltbar gehalten ist.

12. Zeitschalter nach Anspruch 10, dadurch gekennzeichnet, daß der Innenwiderstand des Spannungsteilers (90, 91, 92, 93) insgesamt konstant gehalten ist.

13. Zeitschalter nach Anspruch 10 oder 11, dadurch gekennzeichnet, daß die Umschalter (95, 96, 97, 98) für den Spannungsteiler (90, 91, 92, 93) Teile der Vorrichtung sind, die als Schieberegister (61) ausgestattet sind.

## Claims

1. A timer comprising a feeding direct current voltage source (1) and a capacitor (6), which is adapted to be charged by said source via a switch (15) and can be discharged via a member which switches a load (12) and comprises an oscillator (5) and is flown through by the discharge current from the capacitor (6) during the discharge phase thereof, characterized in that the capacitor consisting of a rectifier (8) and the oscillator (5) and that the oscillator is adapted to be caused to oscillate by a minimum current only in one direction.

2. A timer according to claim 1, characterized in that the capacitor (6) is connected in series with a diode (8) and a resistor (9) and that the supply voltage terminals (28, 27) of the oscillator (5) are connected in parallel to the diode (8).

3. A timer according to claim 1 or 2, characterized in that the diode (8) is poled oppositely to the supply voltage of the oscillator (5) which causes the oscillator (5) to oscillate.

4. A timer according to any of claims 1 to 3, characterized in that the output (30) of the oscillator is connected via a resistor (32) to one terminal (2) of the feeding supply voltage (1).

5. A timer according to any of claims 1 to 4, characterized in that the frequency of the oscillator voltage at its output (30) is much higher than 50 hertz, particularly 10 kilohertz.

6. A timer according to any of claims 1 to 5, characterized in that a further resistor is connected in series with the capacitor (6) in the discharge circuit thereof.

7. A timer according to claim 6, characterized in that said further resistor is replaced by a constant-current source (7).

8. A timer according to claim 6, characterized in that the further resistor is replaced by a controlled current source (Figure 3, Figure 4).

9. A timer according to any of claims 1 to 7, characterized in that a resistor (32) is arranged in the output (30) of the oscillator (5) and is so dimensioned that the oscillator is caused to oscillate by the voltage drop which occurs across said resistor during the flow of the discharge current from the capacitor (6).

10. A timer according to claim 7, characterized in that the controlled current source (60) consists of a parallel circuit of resistors (72, 73, 74, 75 ...) , each of which is connected in series with a switch (76, 77, 78, 79 ...), and said resistors are connected one after the other by a device (61) into the discharge circuit of the capacitor (6).

11. A timer according to claim 7, characterized in that the controlled current source (Figure 4) consists of a voltage divider (90, 91, 92, 93), to which the feeding direct current voltage (2, 3) is applied and the resistance ratio of which is adapted to be switched by a device (61).

12. A timer according to claim 10, characterized in that the total internal resistance of the voltage divider (90, 91, 92, 93) is maintained constant.

13. A timer according to claim 10 or 11, characterized in that the change-over switches (95, 96, 97, 98) for the voltage divider (90, 91, 92, 93) are parts of the device and constitute shift registers (61).

## Revendications

1. Chronorelais avec une source de tension continue (1) et un condensateur (6) chargé par ladite source par l'intermédiaire d'un interrupteur (15) et qui peut être déchargé par un organe comprenant un oscillateur (5) et actionnant une charge (12), cet organe étant parcouru par le courant résultant de la décharge du condensateur (6), caractérisé par le fait que le condensateur (6) est en série avec un montage en parallèle d'un redresseur (8) avec l'oscillateur (5), et que l'oscillateur ne peut être mis en oscillation par un courant minimal que dans un sens.

2. Chronorelais suivant la revendication 1, caractérisé par le fait que le condensateur (6) est en série avec une diode (8) et une résistance (9), et que les connexions de tension de service (28, 27) de l'oscillateur (5) sont en parallèle à la diode (8).

3. Chronorelais suivant la revendication 1 ou 2, caractérisé par le fait que la diode (8) est à polarisation contraire à la tension de service de l'oscillateur (5) laquelle provoque l'oscillation de ce dernier.

4. Chronorelais suivant la revendication 1 à 3, caractérisé par le fait que la sortie (30) de l'oscillateur est reliée par l'intermédiaire d'une résistance (32) à un pôle (2) de la source de tension continue (1).

5. Chronorelais suivant la revendication 1 à 4, caractérisé par le fait que la fréquence de la tension à la sortie (30) de l'oscillateur est de beaucoup supérieure à 50 Hertz, notamment 10 kH.

6. Chronorelais suivant la revendication 1 à 5, caractérisé par le fait qu'en série avec le condensateur (6) se trouve, dans son circuit de décharge, une autre résistance.

7. Chronorelais suivant la revendication 6, caractérisé par le fait que cette autre résistance est remplacée par une source de courant constant (7).

8. Chronorelais suivant la revendication 6, caractérisé par le fait que cette autre résistance est remplacée par une source de courant asservie (fig. 3, fig. 4).

9. Chronorelais suivant la revendication 1 à 7, caractérisé par le fait que la sortie (30) de l'oscillateur (5) est munie d'une résistance (32) conçue de sorte que la chute de tension résultant de l'écoulement du courant de décharge du condensateur (6) met l'oscillateur en oscillation.

10. Chronorelais suivant la revendication 7, caractérisé par le fait que la source de courant asservie (60) se compose d'un montage en parallèle de résistances (72, 73, 74, 75...) dont chacune est en série avec un interrupteur (76, 77, 78, 79...), les résistances étant successivement mises en parallèle dans le circuit de décharge du condensateur (6) par un dispositif (61).

11. Chronorelais suivant la revendication 7, caractérisé par le fait que la source de courant asservie (fig. 4) se compose d'un diviseur de tension (90, 91, 92, 93) alimenté par la tension continue (2, 3), et dont le rapport de division peut être commuté par un dispositif (61).

12. Chronorelais suivant la revendication 10, caractérisé par le fait que la résistance interne du diviseur de tension (90, 91, 92, 93) est maintenue constante dans son ensemble.

13. Chronorelais suivant la revendication 10 ou 11, caractérisé par le fait que les commutateurs (95, 96, 97, 98) pour le diviseur de tension (90, 91, 92, 93) font partie d'un dispositif conçu comme registre à décalage (61).

Fig.1

Fig. 2

Fig. 3

Fig. 4